# EUROPEAN PATENT APPLICATION

(11) **EP 4 726 851 A1**
(43) Date of publication of application: **15.04.2026**
(21) Application number: 25202270.2
(22) Date of filing: 15.09.2025
(51) Int. Cl.: H01M 10/42, H01M 10/48

(54) **SECONDARY BATTERY INSPECTION APPARATUS, SECONDARY BATTERY INSPECTION METHOD, AND SECONDARY BATTERY MANUFACTURING METHOD**

(30) Priority: 08.10.2024 KR 20240136167
(71) Applicant: SAMSUNG SDI CO., LTD., Yongin-si, Gyeonggi-do 17084 (KR)
(72) Inventor: KIM, Jin Mun, 16678 Suwon-si (KR); LEE, Chan Hyung, 16678 Suwon-si (KR); KANG, Su Hyeon, 16678 Suwon-si (KR)
(74) Representative: Marks & Clerk LLP

(57) **Abstract**

The present disclosure relates to a secondary battery inspection apparatus, a secondary battery inspection method, and a secondary battery manufacturing method, and the problem solved by the present disclosure is to identify an internal state of a secondary battery in a non-destructive manner. A secondary battery inspection apparatus according to one embodiment includes a magnetic field generator configured to apply a magnetic field to the secondary battery to be tested, a high frequency generator configured to generate a high frequency of a predetermined frequency and apply the high frequency to the secondary battery to be tested, a sensor configured to detect electromagnetic waves emitted from the secondary battery to be tested to which the high frequency is applied while the magnetic field is applied and a processor configured to determine an internal state of the secondary battery to be tested using the emitted electromagnetic waves detected by the sensor.

## Description

### FIELD

The present disclosure relates to a secondary battery inspection apparatus, a secondary battery inspection method, and a secondary battery manufacturing method.

### BACKGROUND

Secondary batteries are batteries that can be charged and discharged, unlike primary batteries that cannot be recharged. Low-capacity secondary batteries are used in small portable electronic devices such as smartphones, feature phones, notebook computers, digital cameras, and camcorders, while large-capacity secondary batteries are widely used as power sources for driving motors in hybrid vehicles, electric vehicles, and the like and as power storage batteries. These secondary batteries include an electrode including a positive electrode and/or a negative electrode, an electrode assembly including the electrode, a case accommodating the electrode assembly, an electrode terminal connected to the electrode assembly, and the like.

The herein-described information disclosed in the background technology of this disclosure is only intended to improve understanding of the background of the present disclosure and therefore may include information that does not constitute the related art.

### SUMMARY

The present disclosure is directed to providing a secondary battery inspection apparatus, a secondary battery inspection method, and a secondary battery manufacturing method that may identify the internal condition of a secondary battery in a non-destructive manner.

The present disclosure is also directed to providing a secondary battery inspection apparatus, a secondary battery inspection method, and a secondary battery manufacturing method that may identify the quality or shape of a solid electrolyte interface (SEI) film generated in an activation process in real time.

However, the technical problems to be achieved by the present disclosure are not limited to the herein-mentioned problems, and other problems not mentioned will be clearly understood by those skilled in the art from the following description.

According to one embodiment of the present disclosure for solving the above-described technical problem, a secondary battery inspection apparatus includes a magnetic field generator configured to apply a magnetic field to a secondary battery to be tested, a high frequency generator configured to generate a high frequency of a predetermined frequency and apply the high frequency to the secondary battery to be tested, a sensor configured to detect electromagnetic waves emitted from the secondary battery to be tested to which the high frequency is applied while the magnetic field is applied, and a processor configured to determine an internal state of the secondary battery to be tested using the emitted electromagnetic waves detected by the sensor.

According to one aspect of the above embodiment, the high frequency generator may generate the high frequency of a resonance frequency corresponding to a natural frequency of a material inside the secondary battery to be tested and apply the high frequency to the secondary battery to be tested. **In** addition, the high frequency generator may simultaneously generate high frequencies of multiple frequencies and apply the high frequencies to the secondary battery to be tested. **In** addition, the high frequency generator may apply the high frequency of the resonance frequency while scanning the secondary battery to be tested, or the sensor may detect the emitted electromagnetic waves while scanning the secondary battery to be tested.

According to another aspect of the above embodiment, the processor may determine the internal state of the secondary battery to be tested based on at least one of an intensity of the emitted electromagnetic wave or a position from which the emitted electromagnetic wave is emitted from the secondary battery.

According to still another aspect of the above embodiment, the secondary battery to be tested may be a secondary battery in a state before starting an activation process after completion of manufacturing, and the processor may determine an impregnation state of an electrolyte in the secondary battery to be tested. **In** this case, the resonance frequency may be a frequency corresponding to a natural frequency of a material included in the electrolyte of the secondary battery to be tested.

According to yet another aspect of the above embodiment, the secondary battery to be tested may be a secondary battery in a state after starting an activation process after completion of manufacturing, and the processor may determine a shape of a solid electrolyte interface SEI film of the secondary battery to be tested. **In** this case, the resonance frequency may be a frequency corresponding to a natural frequency of at least one of a material included in an electrode active material of the secondary battery to be tested and a material included in the solid electrolyte interface film. **In** this case, the processor may determine a thickness of the solid electrolyte interface film of the secondary battery to be tested.

According to yet another aspect of the above embodiment, the processor may determine presence or absence of a foreign substance included in the secondary battery to be tested. **In** this case, the foreign substance may be a metal foreign substance, and the resonance frequency may be a frequency corresponding to a natural frequency of the metal foreign substance. **In** addition, the high frequency generator may apply the high frequency of the resonance frequency while scanning the secondary battery to be tested, or the sensor detects the emitted electromagnetic waves while scanning the secondary battery to be tested, and the processor may determine a position of a foreign substance included in the the secondary battery to be tested.

According to one embodiment of the present disclosure for solving the above-described problem, a secondary battery inspection method includes applying a magnetic field to a secondary battery to be tested, applying a high frequency of a predetermined frequency to the secondary battery to be tested to which the magnetic field is applied, detecting electromagnetic waves emitted from the secondary battery to be tested to which the high frequency is applied, and determining an internal state of the secondary battery to be tested using the emitted electromagnetic waves detected in the detecting of the electromagnetic waves.

According to one aspect of the embodiment, in the applying of the high frequency, the high frequency of a resonance frequency corresponding to a natural frequency of a material inside the secondary battery to be tested may be applied to the secondary battery to be tested. **In** addition, in the applying of the high frequency, the high frequencies of multiple frequencies may be simultaneously applied to the secondary battery to be tested.

According to another aspect of the above embodiment, the secondary battery to be tested may be a secondary battery in a state before starting an activation process after completion of manufacturing, and the method may further comprise determining an impregnation state of an electrolyte in the secondary battery to be tested.

According to still another aspect of the above embodiment, the secondary battery to be tested may be a secondary battery in a state after starting an activation process after completion of manufacturing, and the method may further comprise determining a shape of a solid electrolyte interface (SEI) film of the secondary battery to be tested.

According to yet another aspect of the above embodiment, the method may further comprise determining presence or absence of a foreign substance included in the secondary battery to be tested.

According to one embodiment of the present disclosure for solving the above-described problem, a method of manufacturing a secondary battery includes an inspection process of inspecting an internal state of the secondary battery using a high frequency of a resonance frequency corresponding to a natural frequency of a material inside the secondary battery, and the inspection process includes applying a magnetic field to the secondary battery, applying the high frequency of a predetermined frequency to the secondary battery to which the magnetic field is applied, detecting electromagnetic waves emitted from the secondary battery to be tested to which the high frequency is applied, and determining an internal state of the secondary battery to be tested using the emitted electromagnetic waves detected in the detecting of the electromagnetic waves.

At least some of the above and other features of the invention are set out in the claims.

### BRIEF DESCRIPTION OF THE DRAWINGS

The following drawings attached to this specification illustrate preferred embodiments of the present disclosure and, together with the detailed description of the disclosure described hereinafter, serve to further understand the technical idea of the present disclosure, therefore the present disclosure should not be construed as being limited to matters described in such drawings, in which:
FIG. 1 is a drawing schematically illustrating a cylindrical secondary battery that can be applied to embodiments of the present disclosure;
FIG 2 is a cross-sectional view schematically illustrating a prismatic secondary battery that can be applied according to embodiments of the present disclosure;
FIG. 3 is a drawing schematically illustrating an example of a pouch-type secondary battery that can be applied to embodiments of the present disclosure;
FIG. 4 is a drawing schematically illustrating another example of the pouch-type secondary battery that can be applied to embodiments of the present disclosure;
FIG. 5 is a block diagram showing a schematic configuration of a secondary battery inspection apparatus according to embodiments of the present disclosure;
FIG. 6 is a drawing schematically illustrating the process in which electromagnetic waves are emitted from a secondary battery by the resonance phenomenon;
FIG. 7A is a drawing schematically illustrating a state in which injection of an electrolyte into a secondary battery is completed;
FIG. 7B is a graph showing an example of the intensity of electromagnetic waves emitted from the secondary battery of FIG. 7A; and
FIG. 8 is a flowchart showing an example of a secondary battery inspection method according to embodimentsof the present disclosure.

### DETAILED DESCRIPTION

Hereinafter, preferred embodiments of the present disclosure will be described in detail with reference to the accompanying drawings. Prior to this, the terms or words used in the specification and claims should not be interpreted as limited to their usual or dictionary meanings, and should be interpreted in meanings and concepts that are consistent with the technical concept of the present disclosure based on the principle that the present inventor can appropriately define the concepts of the terms in order to explain her or her disclosure in its best way. Accordingly, it should be understood that the configurations shown in the drawings and the embodiments described herein are only preferred embodiments of the present disclosure and are not intended to represent all of the technical ideas of the disclosure, and that there may be various equivalents and modifications that may be substituted for them at the time of this application.

In addition, when used herein, the terms "comprise," and "include," and/or "comprising," and "including" specify the presence of stated features, numbers, steps, operations, members, elements and/or groups thereof, but do not exclude the presence or addition of one or more other features, numbers, operations, members, elements and/or groups thereof.

In addition, to aid understanding of the disclosure, the accompanying drawings are not drawn to scale and the dimensions of some components may be exaggerated. In addition, the same reference numbers may be assigned to the same components in different embodiments.

When two things being compared are said to be "same", it means they are "substantially the same." Therefore, "substantially same" may include deviations that are considered low in the art, for example, deviations of less than 5%. In addition, uniformity of a parameter in a given area may imply uniformity from an average point of view.

Although "first," "second," and the like are used to describe various components, these components are not limited by these terms. These terms are used only to distinguish one component from another, and unless specifically stated otherwise, it is to be understood that a first component may also be a second component.

Throughout the specification, unless specifically stated otherwise, each element may be singular or plural.

The arrangement of an arbitrary component on the "upper portion (or lower portion)" of a component or "above (or below)" the component means that the arbitrary component is not only disposed in contact with the upper surface (or lower surface) of the component, but also other components may be interposed between the component and the arbitrary component disposed on (or under) the component.

In addition, when a component is described as being "on," "connected to," or "coupled to" another component, it is to be understood that the components may be directly coupled or connected to one another, but that other components may be "interposed" between the components, or that each component may be "connected," "coupled," or "linked" through another component.

As used herein, the term "and/or" includes any and all combinations of one or more of the associated listed items. In addition, the use of "may" when describing embodiments of the present disclosure relates to "one or more embodiments of the present disclosure." Expressions like "at least one" and "one or more" before a list of elements modify the entire list of elements and do not modify individual elements in the list.

Throughout the specification, when "A and/or B" is used, this means A, B, or A and B unless otherwise specified, and when "C to D" is used, this means C or more and D or less, unless otherwise specified.

When phrases such as "at least one of A, B, and C", "at least one of A, B, or C", "at least one selected from the group A, B, and C" or "at least one selected from A, B, and C" are used to specify a list of elements A, B, and C, the phrases can refer to any suitable combination.

The term "use" may be considered synonymous with the term "utilize". As used herein, the terms "substantially," "about," and similar terms are used as terms of approximation rather than as terms of degree, and are intended to take into account the inherent variation in measured or calculated values that will be recognized by those of ordinary skill in the art.

Although the terms first, second, third, and the like may be used in this specification to describe various elements, components, areas, layers and/or sections, these elements, components, areas, layers and/or sections should not be limited by these terms. This term is used to distinguish one element, component, area, drawing layer, or section from another element, component, area, drawing layer, or section. Accordingly, a first element, component, area, class, or section discussed herein may be named a second element, component, area, class, or section without departing from the teachings of the example embodiments.

For ease of description, spatial relative terms such as "lower portion (beneath)," "Hereinafter," "lower," "upper portion (above)," "upper," and the like may be used herein to describe the relationship of one element or feature to another element(s) or feature(s) as depicted in the drawings. Spatially relative positions will be understood to encompass different directions of the device in use or operation in addition to the direction depicted in the figures. For example, when a device in a drawing is flipped, an element described as "below" or "lower portion" another element is understood to be "above" or "upper portion" the other element. Therefore, the term "below" can encompass both the upward and downward directions.

The terminology used herein is for the purpose of describing embodiments of the present disclosure and is not intended to be limiting of the present disclosure.

As technology advances, higher capacity secondary batteries are required. Accordingly, a plurality of secondary batteries may be electrically connected and used. For example, the secondary battery may be applied to electronic devices in the form of a secondary battery module including a plurality of secondary batteries, and/or a secondary battery pack including a plurality of secondary battery modules. **In** some embodiments, a secondary battery pack is formed by the plurality of secondary batteries. At this time, electronic devices include electronic devices that require high output and/or high capacity secondary batteries, such as electric vehicles.

Among secondary batteries, the one that is currently receiving the most attention is lithium secondary batteries. A lithium secondary battery is a battery composed of a positive electrode, a negative electrode, and an electrolyte and a separator that provide a path for lithium ions to move between the positive electrode and the negative electrode. When a voltage is applied after manufacturing a lithium secondary battery, lithium ions move from the positive electrode to the negative electrode and chemically react with additives in the electrolyte. This process is called an activation process. Through the activation process, a thin solid film called the solid electrolyte interface (SEI) is created at the interface of the negative electrode. As a result, the secondary battery becomes electrochemically stable and ready for use.
The SEI film is one of the factors that greatly influences the safety, power capacity, leakage current, storage life, and lifetime of secondary batteries. In addition, an internal state of the secondary battery, including the SEI film, directly affects the performance of the secondary battery. Accordingly, prior to using the secondary battery, inspection is usually performed on the state of the SEI film as well as the quality and defects inside the secondary battery.

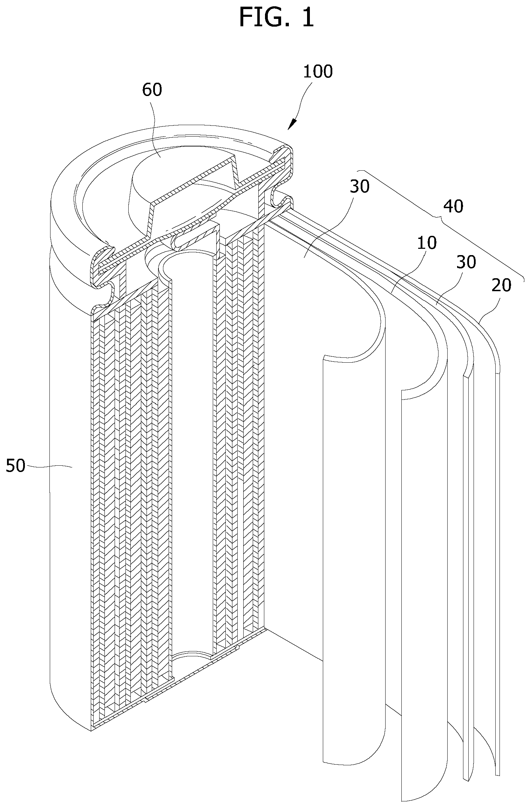

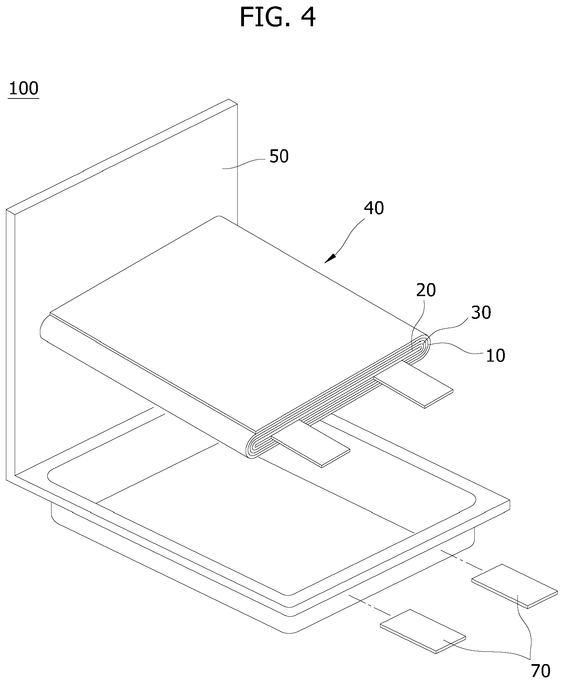

FIGS. 1 and 4 are views schematically illustrating a secondary battery that can be applied according to one embodiment of the present disclosure;

### Secondary battery 100

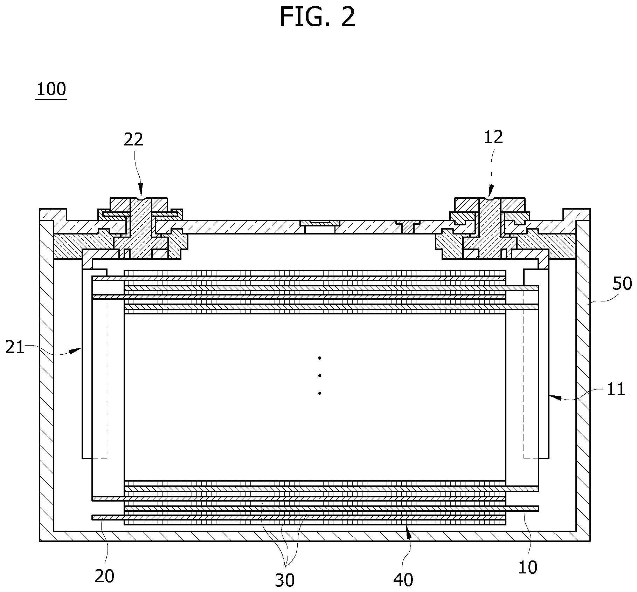

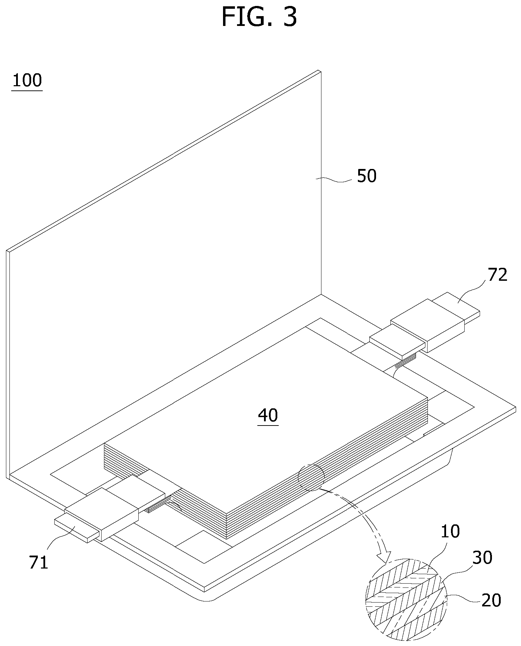

The secondary battery 100 can be classified into cylindrical, prismatic, pouch-shaped, and coin-shaped secondary batteries, or the like, depending on its shape. FIGS. 1 to 4 are schematic diagrams illustrating secondary batteries according to one embodiment, FIG. 1 may be one type of cylindrical secondary battery, FIG. 2 may be one type of prismatic secondary battery, and FIGS. 3 and 4 may be one type of pouch-shaped secondary batteries. Referring to FIGS. 1 and 4, the secondary battery 100 may include an electrode assembly 40 having a separator 30 interposed between a positive electrode 10 and a negative electrode 20, and a case 50 into which the electrode assembly 40 is built. The positive electrode 10, the negative electrode 20 and the separator 30 may be impregnated with an electrolyte (not shown). The secondary battery 100 may include a sealing member 60 that seals the case 50 as shown in FIG. 1. In addition, in FIG. 2, the secondary battery 100 may include a positive electrode lead tab 11, a positive electrode terminal 12, a negative electrode lead tab 21, and a negative electrode terminal 22. As shown in FIGS. 3 and 4, the secondary battery 100 may include electrode tabs 70, i.e., a positive electrode tab 71 and a negative electrode tab 72, which serve as electrical paths for conducting current formed in the electrode assembly 40 to the outside.

### Positive electrode active material

For the positive electrode active material, a compound capable of reversible intercalation and deintercalation of lithium (lithiated intercalation compound) may be used. Specifically, at least one of composite oxides of lithium and a metal selected from cobalt, manganese, nickel, or a combination thereof may be used.

The composite oxide may be a lithium transition metal composite oxide, and specific examples thereof may include lithium nickel-based oxides, lithium cobalt-based oxides, lithium manganese-based oxides, lithium iron phosphate-based compounds, cobalt-free nickel-manganese-based oxides, or a combination thereof.

As an example, a compound represented by any one of the following chemical formulas may be used. LiₐA_{1-b}X_{b}O_{2-c}D_{c}(0.90≤a≤1.8, 0≤b≤0.5, 0≤c≤0.05); LiₐMn_{2-b}X_{b}O_{4-c}D_{c}(0.90≤a≤1.8, 0≤b≤0.5, 0≤c≤0.05); LiₐNi_{1-b-c}Co_{b}X_{c}O_{2-α}D_{α}(0.90≤a≤1.8, 0≤b≤0.5, 0≤c≤0.5, 0<α<2); LiₐNi_{1-b-c}Mn_{b}X_{c}O_{2-α}D_{α}(0.90≤a≤1.8, 0≤b≤0.5, 0≤c≤0.5, 0<α<2); LiₐNi_{b}Co_{c}L¹_{d}GₑO₂(0.90≤a≤1.8, 0≤b≤0.9, 0≤c≤0.5, 0≤d≤0.5, 0≤e≤0.1); LiₐNiG_{b}O₂(0.90≤a≤1.8, 0.001≤b≤0.1); LiₐCoG_{b}O₂(0.90≤a≤1.8, 0.001≤b≤0.1); LiₐMn_{1-b}G_{b}O₂(0.90≤a≤1.8, 0.001≤b≤0.1); LiₐMn₂G_{b}O₄(0.90≤a≤1.8, 0.001≤b≤0.1); LiₐMn_{1-g}G_{g}PO₄(0.90≤a≤1.8, 0≤g≤0.5); Li_{(3-f)}Fe₂(PO₄)₃(0≤f≤2); and LiₐFePO₄(0.90≤a≤1.8).

In the chemical formulas, A is Ni, Co, Mn, or a combination thereof; X is Al, Ni, Co, Mn, Cr, Fe, Mg, Sr, V, a rare earth element, or a combination thereof; D is O, F, S, P, or a combination thereof; G is Al, Cr, Mn, Fe, Mg, La, Ce, Sr, V, or a combination thereof; and L¹ is Mn, Al, or a combination thereof.

For example, the positive electrode active material may be a high-nickel positive electrode active material in which a nickel content is 80 mol% or more, 85 mol% or more, 90 mol% or more, 91 mol% or more, or 94 mol% or more and 99 mol% or less, based on 100 mol% of metal excluding lithium in a lithium transition metal composite oxide. The high-nickel positive electrode active material can achieve high capacity and thus can be applied to high-capacity, high-density secondary batteries.

### Positive electrode 10

The positive electrode 10 for the secondary battery 100 may include a current collector and a positive electrode active material layer formed on the current collector. The positive electrode active material layer includes a positive electrode active material and may further include a binder and/or a conductive material.

For example, the positive electrode may further include an additive that may act as a sacrificial positive electrode.

The content of the positive electrode active material may be 90 wt% to 99.5 wt% based on 100 wt% of the positive electrode active material layer, and the content of the binder and conductive material may be 0.5 wt% to 5 wt%, respectively, based on 100 wt% of the positive electrode active material layer.

The binder serves to securely attach the positive electrode active material particles to each other and also to securely attach the positive electrode active material to the current collector. Representative examples of the binder include, but are not limited to, polyvinyl alcohol, carboxymethyl cellulose, hydroxypropyl cellulose, diacetyl cellulose, polyvinyl chloride, carboxylated polyvinyl chloride, polyvinyl fluoride, an ethylene oxide-containing polymer, polyvinyl pyrrolidone, polyurethane, polytetrafluoroethylene, polyvinylidene fluoride, polyethylene, polypropylene, styrene-butadiene rubber, (meth)acrylated styrene-butadiene rubber, epoxy resin, (meth)acrylic resin, polyester resin, nylon, and the like.

The conductive material is used for imparting conductivity to an electrode, and any material that does not cause chemical changes and is electronically conductive may be used in the battery being constructed. Examples of the conductive material include carbon-based materials such as natural graphite, artificial graphite, carbon black, acetylene black, Ketjen black, carbon fibers, carbon nanofibers, and carbon nanotubes; metal-based materials containing copper, nickel, aluminum, and silver in the form of metal powder or metal fibers; conductive polymers such as polyphenylene derivatives; or mixtures thereof.

Al may be used as the current collector, but the present disclosure is not limited thereto.

### Negative electrode active material

The negative electrode active material includes a material capable of reversibly intercalating/deintercalating lithium ions, a lithium metal, an alloy of lithium and a metal, a material capable of doping and dedoping lithium, or a transition metal oxide.

The material capable of reversibly intercalating/deintercalating lithium ions may be a carbon-based negative electrode active material, and for example, may include crystalline carbon, amorphous carbon, or a combination thereof. Examples of the crystalline carbon may include graphite such as amorphous, platy, flaky, spherical or fibrous natural graphite or artificial graphite, and examples of the amorphous carbon may include soft carbon, hard carbon, mesophase pitch carbide, calcined coke, etc.

As the alloy of lithium and a metal, an alloy of lithium and a metal selected from Na, K, Rb, Cs, Fr, Be, Mg, Ca, Sr, Si, Sb, Pb, In, Zn, Ba, Ra, Ge, Al, and Sn may be used.

As the material capable of doping and dedoping lithium, a Si-based negative electrode active material or a Sn-based negative electrode active material may be used. The Si-based negative electrode active material may include silicon, a silicon-carbon composite, SiOₓ (0 < x < 2), a Si-Q alloy (where Q is selected from an alkali metal, an alkaline earth metal, a Group 13 element, a Group 14 element (excluding Si), a Group 15 element, a Group 16 element, a transition metal, a rare earth element, and a combination thereof), or a combination thereof. The Sn-based negative electrode active material may include Sn, SnO₂, a Sn-based alloy, or a combination thereof.

The silicon-carbon composite may be a composite of silicon and amorphous carbon. According to one embodiment, the silicon-carbon composite may be in the form of silicon particles whose surface is coated with amorphous carbon. For example, the silicon-carbon composite may include a secondary particle (core) in which silicon primary particles are assembled and an amorphous carbon coating layer (shell) located on the surface of the secondary particle. The amorphous carbon may also be located between the silicon primary particles, so that, for example, the silicon primary particles may be coated with the amorphous carbon. The secondary particles may be dispersed in an amorphous carbon matrix.

The silicon-carbon composite may further include crystalline carbon. For example, the silicon-carbon composite may include a core including crystalline carbon and silicon particles and an amorphous carbon coating layer located on the surface of the core.

The Si-based negative electrode active material or Sn-based negative electrode active material may be used in a combination with a carbon-based negative electrode active material.

### Negative electrode 20

The negative electrode 20 for the secondary battery 100 includes a current collector and a negative electrode active material layer located on the current collector. The negative electrode active material layer includes a negative electrode active material and may further include a binder and/or a conductive material.

For example, the negative electrode active material layer may include 90 to 99 wt% of the negative electrode active material, 0.5 to 5 wt% of the binder, and 0 to 5 wt% of the conductive material.

The binder serves to securely attach the negative electrode active material particles to each other and also to securely attach the negative electrode active material to the current collector. The binder may include a non-aqueous binder, an aqueous binder, a dry binder, or a combination thereof.

The non-aqueous binder may include polyvinyl chloride, carboxylated polyvinyl chloride, polyvinyl fluoride, an ethylene propylene copolymer, polystyrene, polyurethane, polytetrafluoroethylene, polyvinylidene fluoride, polyethylene, polypropylene, polyamideimide, polyimide, or a combination thereof.

The aqueous binder may be selected from styrene-butadiene rubber, (meth)acrylated styrene-butadiene rubber, (meth)acrylonitrile-butadiene rubber, (meth)acrylic rubber, butyl rubber, a fluoroelastomer, polyethylene oxide, polyvinylpyrrolidone, polyepichlorohydrin, polyphosphazene, poly(meth)acrylonitrile, an ethylene propylene diene copolymer, polyvinylpyridine, chlorosulfonated polyethylene, latex, polyester resin, (meth)acrylic resin, phenol resin, epoxy resin, polyvinyl alcohol, and a combination thereof.

When using the aqueous binder as the negative electrode binder, a cellulose-based compound capable of imparting viscosity may be further included. As the cellulose-based compound, one or more types of carboxymethyl cellulose, hydroxypropyl methyl cellulose, methyl cellulose, or alkali metal salts thereof may be used in combination. As the alkali metal, Na, K, or Li may be used.

The dry binder is a polymeric material that can be fiberized, and may be, for example, polytetrafluoroethylene, polyvinylidene fluoride, a polyvinylidene fluoride-hexafluoropropylene copolymer, polyethylene oxide, or a combination thereof.

The conductive material is used for imparting conductivity to an electrode, and any material that does not cause chemical changes and is electronically conductive may be used in the battery being constructed. Specific examples may include carbon-based materials such as natural graphite, artificial graphite, carbon black, acetylene black, Ketjen black, carbon fibers, carbon nanofibers, and carbon nanotubes; metal-based materials containing copper, nickel, aluminum, and silver in the form of metal powder or metal fibers; conductive polymers such as polyphenylene derivatives; or mixtures thereof.

As the negative electrode current collector, any material selected from a copper foil, a nickel foil, a stainless steel foil, a titanium foil, a nickel foam, a copper foam, a polymer substrate coated with a conductive metal, and a combination thereof may be used.

### Electrolyte (not shown)

The electrolyte for the secondary battery 100 includes a non-aqueous organic solvent and a lithium salt.

The non-aqueous organic solvent acts as a medium through which ions involved in the electrochemical reaction of the battery can move.

The non-aqueous organic solvent may be a carbonate-based, ester-based, ether-based, ketone-based, or alcohol-based solvent, an aprotic solvent, or a combination thereof.

Examples of the carbonate-based solvents may include dimethyl carbonate (DMC), diethyl carbonate (DEC), dipropyl carbonate (DPC), methylpropyl carbonate (MPC), ethylpropyl carbonate (EPC), methylethyl carbonate (MEC), ethylene carbonate (EC), propylene carbonate (PC), butylene carbonate (BC), and the like.

Examples of the ester-based solvent include methyl acetate, ethyl acetate, n-propyl acetate, dimethyl acetate, methyl propionate, ethyl propionate, decanolide, mevalonolactone, and valerolactone, caprolactone, and the like.

Examples of the ether-based solvent may include dibutyl ether, tetraglyme, diglyme, dimethoxyethane, 2-methyltetrahydrofuran, 2,5-dimethyltetrahydrofuran, and tetrahydrofuran. In addition, cyclohexanone and the like may be used as the ketone-based solvent. Ethyl alcohol, isopropyl alcohol, and the like may be used as the alcohol-based solvent, and nitriles such as R-CN (where R is a linear, branched, or cyclic hydrocarbon group having 2 to 20 carbon atoms and may include a double bond, an aromatic ring, or an ether group); amides such as dimethylformamide; dioxolanes such as 1,3-dioxolane and 1,4-dioxolane; sulfolanes; and the like may be used as the aprotic solvent.

The non-aqueous organic solvent may be used alone or in combination of two or more.

In addition, when using the carbonate-based solvent, a mixture of a cyclic carbonate and a chain carbonate may be used, and the cyclic carbonate and the chain carbonate may be mixed in a volume ratio of 1:1 to 1:9.

The lithium salt is a material that is dissolved in an organic solvent and acts as a source of lithium ions within the battery, enabling the basic operation of the secondary battery and promoting the movement of lithium ions between the positive electrode and the negative electrode. Representative examples of the lithium salts may include one or two or more lithium salt selected from LiPF₆, LiBF₄, LiSbF₆, LiAsF₆, LiClO₄, LiAlO₂, LiAlCl₄, LiPO₂F₂, LiCl, LiI, LiN(SO₃C₂F₅)₂, Li(FSO₂)₂N (lithium bis(fluorosulfonyl)imide (LiFSI), LiC₄F₉SO₃, LiN(CₓF₂ₓ₊₁SO₂)(C_{y}F_{2y+1}SO₂) (where x and y are integers from 1 to 20), lithium trifluoromethanesulfonate, lithium tetrafluoroethanesulfonate, lithium difluorobis(oxalato)phosphate (LiDFOB), and lithium bis(oxalato)borate (LiBOB).

### Separator 30

Depending on the type of secondary battery 100, the separator 30 may be present between the positive electrode 10 and the negative electrode 20. For the separator 30, polyethylene, polypropylene, polyvinylidene fluoride, or a multilayer film of two or more layers thereof may be used, and a mixed multilayer film such as a polyethylene/polypropylene two-layer separator, a polyethylene/polypropylene/polyethylene three-layer separator, or a polypropylene/polyethylene/polypropylene three-layer separator may also be used.

The separator 30 may include a porous substrate, and a coating layer including an organic material, an inorganic material, or a combination thereof, located on one side or both sides of the porous substrate.

The porous substrate may include a polymer film formed of at least one polymer selected from polyolefins such as polyethylene and polypropylene, polyesters such as polyethylene terephthalate and polybutylene terephthalate, polyacetal, polyamide, polyimide, polycarbonate, polyether ketone, polyarylether ketone, polyether imide, polyamide imide, polybenzimidazole, polyether sulfone, polyphenylene oxide, a cyclic olefin copolymer, polyphenylene sulfide, polyethylene naphthalate, glass fiber, Teflon, and polytetrafluoroethylene, or two or more copolymers or mixtures of thereof.

The organic material may include a polyvinylidene fluoride-based polymer or a (meth)acrylic polymer.

The inorganic material may include inorganic particles selected from Al₂O₃, SiO₂, TiO₂, SnO₂, CeO₂, MgO, NiO, CaO, GaO, ZnO, ZrO₂, Y₂O₃, SrTiO₃, BaTiO₃, Mg(OH)₂, boehmite, and a combination thereof, but is not limited thereto.

The organic material and the inorganic material may be present in a mixed form in one coating layer or may be present in a form in which a coating layer including an organic material and a coating layer including an inorganic material are stacked.

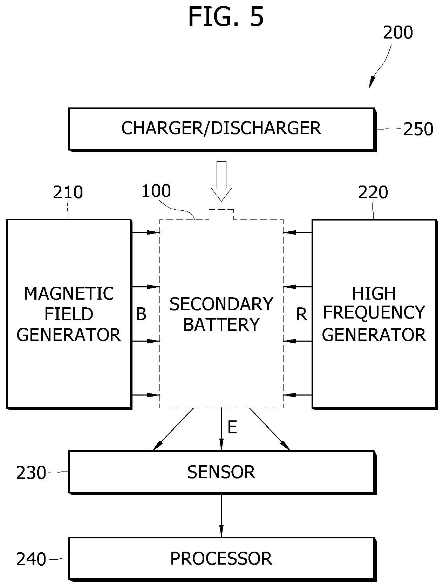

FIG. 5 is a block diagram showing a schematic configuration of a secondary battery inspection apparatus according to one embodiment of the present disclosure.

A secondary battery inspection apparatus 200 of FIG. 5 is a device for inspecting the internal state, quality, presence of defects, and the like of a secondary battery 100 to be inspected (e.g., a secondary battery to be tested). **In** particular, the secondary battery inspection apparatus 200 may be used to inspect the internal state of the secondary battery 100 before performing an activation process prior to use of the secondary battery 100 or during the activation process. However, aspects of the technology described herein is not limited thereto, and the secondary battery inspection apparatus 200 may be used to perform inspection on the secondary battery 100 after completing the activation process or to perform inspection on the secondary battery 100 that is already in use.

The secondary battery inspection apparatus 200 is an apparatus that inspects the inside of the secondary battery 100 using the principle of magnetic resonance. 'Magnetic resonance' refers to a resonance phenomenon that occurs when a proton or electron having a magnetic moment is disposed in a magnetic field and waveform energy such as an electromagnetic wave is applied, and the proton or electron absorbs waveform energy of a specific frequency. According to the present embodiment, the secondary battery inspection apparatus 200 may determine or identify the internal structure of the secondary battery 100, the thickness of a specific material layer, the presence of foreign substances, and the like, using the frequency at which a magnetic resonance phenomenon occurs, which corresponds to the natural frequency of a specific material inside the secondary battery 100.

Referring to FIG. 5, the secondary battery inspection apparatus 200 includes a magnetic field generator 210, a high frequency generator 220, a sensor 230, and a processor 240. Although not shown in the drawing, the secondary battery inspection apparatus 200 may further include a support unit for physically supporting or mounting the secondary battery 100 to be inspected.

The secondary battery inspection apparatus 200 may further include a charger/discharger 250. The charger/discharger 250 is a device that is electrically connected to the external terminal of the secondary battery 100 to charge/discharge the secondary battery 100, and there are no special restrictions on its configuration. Depending on the embodiment, the secondary battery inspection apparatus 200 may further include a unit for pressurizing, heating, and/or creating a vacuum environment for the secondary battery 100.

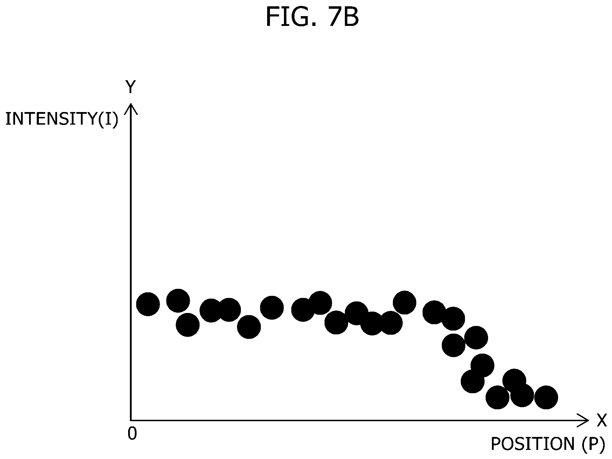

The magnetic field generator 210 FIG. 7B is a unit for generating a magnetic field B and applying the magnetic field B to the secondary battery 100. When the magnetic field B is not applied, the rotation axis of protons of materials present inside the secondary battery 100, such as electrode active materials, materials included in the electrolyte, and materials included in the SEI film, points in an arbitrary direction. That is, the rotation axis of protons of a particular material is not fixed in direction, but each has a random direction. On the other hand, when the magnetic field B is applied to the secondary battery 100, the rotation axes of the protons of the material present inside the secondary battery 100 may all be arranged parallel to each other in a direction that conforms to the magnetic flux direction of the magnetic field (B). As a result, the material present inside the secondary battery 100 may be arranged to have relatively low energy.

According to the present embodiment, there is no particular limitation on the type of the magnetic field generator 210, and any magnetic field generator known in the art may be applied regardless of its type. For example, the magnetic field generator 210 may be a device that uses a magnetic material such as a permanent magnet or an electromagnet, or a device in which a coil such as a solenoid coil is connected to an AC power source.

This magnetic field generator 210 is disposed on one side of the secondary battery 100 and generates and applies a magnetic field B of a desired strength to the secondary battery 100. For example, the magnetic field generator 210 may generate a magnetic field B having a strength between 0.01 and 4 Tesla (T) and apply the magnetic field to the secondary battery 100, but is not **limited** thereto.

The high frequency generator 220 is a unit for generating a signal of a high frequency (radio frequency, R) in contrast to a low frequency and applying the signal to the secondary battery 100. Here, the high frequency R may refer to a radio frequency having a high frequency of, for example, 10³ hertz (Hz) or higher. There is no specific limit to the upper frequency limit of the high frequency, which may be, for example, 10²⁰ Hz or less. The high frequency R may be a pulse wave, but is not limited to this and may also be a sinusoidal wave such as a sine wave.

The high frequency generator 220 may be disposed adjacent to the secondary battery 100 so as to apply the high frequency R to the secondary battery 100. **In** addition, the high frequency generator 220 may be disposed in a direction that does not overlap the magnetic field generator 210. For example, the high frequency generator 220 may be disposed opposite to the magnetic field generator 210 with the secondary battery 100 interposed therebetween, but is not limited thereto.

According to one aspect of the present embodiment, the high frequency generator 220 may apply a high frequency R of a predetermined frequency to the secondary battery 100 while the magnetic field B generated by the magnetic field generator 210 is applied to the secondary battery 100. Here, the predetermined frequency may be a resonance frequency of a material, which is one of the materials inside the secondary battery 100. In this way, when a resonance frequency of a specific material present in the secondary battery 100 is applied, electromagnetic waves (emitted electromagnetic waves) due to the resonance phenomenon of the material may be emitted from the secondary battery 100.

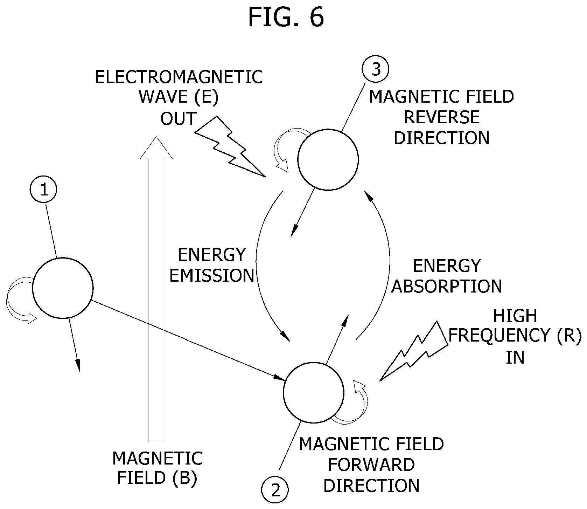

FIG. 6 is a drawing schematically illustrating the process in which the electromagnetic waves are emitted from the secondary battery 100 by the resonance phenomenon.

Referring to FIG. 6, before the magnetic field B is applied by the magnetic field generator 210, the rotation axis (magnetic moment) of protons of the internal material of the secondary battery 100 points in an arbitrary direction (see ① of FIG. 6). In addition, when the magnetic field B is applied by the magnetic field generator 210, the internal material is converted so that the rotation axis of the protons are directed in a direction which conforms to the magnetic field B (magnetic field forward direction) (see ② of FIG. 6). As a result, the internal material is arranged in a relatively low energy state.

Next, when the high frequency R of the resonance frequency of the internal material is applied to the secondary battery 100 using the high frequency generator 220, the internal material of the secondary battery 100 absorbs the energy of the high frequency R, and the rotation axis of protons of the internal material points in the opposite direction to the direction which conforms to the magnetic field (see ③ of FIG. 6). As a result, the internal material is arranged in a relatively high energy state.

Next, the internal material arranged in a high energy state returns to the direction in which the rotation axis of protons conforms to the magnetic field B due to the magnetic field B applied from the magnetic field generator 210, and becomes a low energy state (see ② of FIG. 6). In addition, the extra energy (energy difference) generated during this process is emitted from the secondary battery 100 as a predetermined waveform energy, for example, an electromagnetic wave E of a predetermined energy.

According to another aspect of the present embodiment, the high frequency generator 220 may apply the high frequency R to the secondary battery 100 while changing the frequency of the applied high frequency (e.g., performing a frequency scan). For this purpose, the high frequency generator 220 may be a device having a variable frequency generation function. For example, when the type of material present inside the secondary battery 100 is not known, the high frequency generator 220 may apply the high frequency R while performing a frequency scan. According to this, the size of the resonance frequency at which resonance occurs in the internal material may be used to identify what the internal material is.

Alternatively, the high frequency generator 220 may apply the high frequency R of a specific frequency (e.g., a resonance frequency), but may also move the position in the secondary battery 100 to which the high frequency R is applied (area scan). For this purpose, the high frequency generator 220 may be installed movably with respect to the secondary battery 100. For example, when the type of material that is present or is likely to be present inside the secondary battery 100 is known, but whether the material is present and/or the position where it is present are not known, the high frequency generator 220 may apply the high frequency R while performing an area scan on the secondary battery 100. According to this, it is possible to identify the position of the internal material where the resonance phenomenon occurs in the secondary cell 100.

Alternatively, the high frequency generator 220 may perform both frequency scan and area scan on the secondary battery 100. For example, the high frequency generator 220 can first perform a frequency scan on the secondary battery 100 to find a resonance frequency, and then perform an area scan using the found resonance frequency. According to this, the type of internal material and its position may be identified together.

According to another aspect of the present embodiment, high frequencies of multiple frequencies may be applied simultaneously to the secondary battery 100. For this purpose, the high frequency generator 220 may have a function of generating multiple wavelength frequencies simultaneously. According to this, the high frequency generator 220 may perform a frequency scan for a specific frequency range more quickly. **In** addition, the high frequency generator 220 may simultaneously perform detection of the presence and/or position of a plurality of materials.

The sensor 230 is a device for detecting electromagnetic waves (E, emitted electromagnetic waves) emitted from the secondary battery 100. More specifically, the sensor 230 may detect the electromagnetic waves E emitted from the secondary battery 100 when a high frequency R of a predetermined frequency is applied to the secondary battery 100. **In** addition, the sensor 230 that detects the emitted electromagnetic waves E can convert the emitted electromagnetic waves into predetermined electrical signals and output the electrical signals to the outside, i.e., to the processor 240. The sensor 230 can be any device capable of detecting the electromagnetic waves E emitted from the secondary battery 100, and there is no particular limitation on its type.

The sensor 230 may be installed at any position capable of detecting the emitted electromagnetic waves E. **In** the block diagram of FIG. 5, the sensor 230 is disposed at the lower side of the secondary battery 100, but this is only for convenience of illustration. In addition, there is no particular limitation on the size or shape of the sensor 230, but any size and shape that may efficiently detect the emitted electromagnetic waves E are sufficient. For example, the sensor 230 may have a flat shape with a size that faces the entire surface of the secondary battery 100 or a curved shape with a size that surrounds the entire surface of the secondary battery 100. Alternatively, the sensor 230 may have a flat (or linear or rectangular) shape or curved shape with a size that faces a portion of one surface of the secondary battery 100. In this case, the sensor 230 may be installed movably with respect to the secondary battery 100 so that the sensor 230 can scan the entire surface of the secondary battery 100.

For example, the sensor 230 may be installed in the same direction as the high frequency generator 220. In this case, the sensor 230 may be a separate device that is separate from the high frequency generator 220. Alternatively, the sensor 230 may be implemented integrally with the high frequency generator 220.

According to one aspect of the present embodiment, the sensor 230 may generate a predetermined electrical signal based on the intensity of the detected emitted electromagnetic waves E and output the electrical signal to the processor 240. The intensity of the emitted electromagnetic waves E detected by the sensor 230 may vary depending on the internal structure or condition of the secondary battery 100, the presence or absence of a specific material, and the like. Hereinafter, this will be explained in detail with an example.

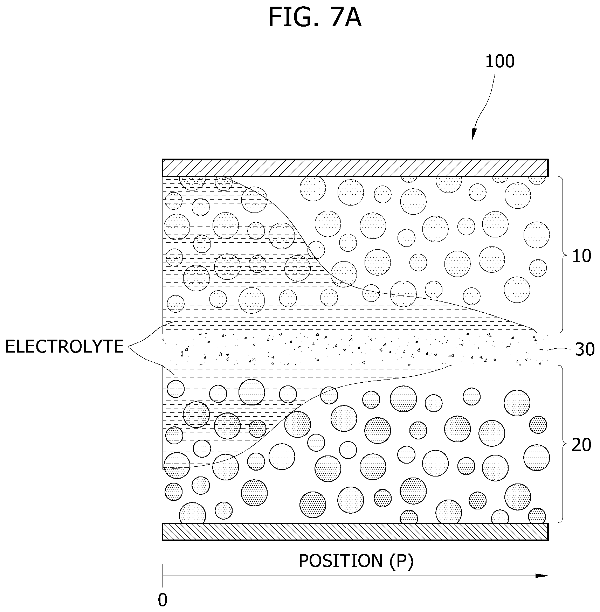

FIG. 7A is a drawing schematically illustrating a state in which injection of an electrolyte into the secondary battery is completed. Here, the secondary battery 100 may be in a state before the activation process is initiated, after the injection of the electrolyte is completed after completion of manufacturing.

Referring to FIG. 7A, the secondary battery 100 includes a positive electrode 10, a negative electrode 20, and a separator 30 interposed between the electrodes 10 and 20. In addition, the positive electrode 10 includes a current collector and a positive electrode active material layer formed on the current collector, and the negative electrode 20 includes a current collector and a negative electrode active material layer formed on the current collector. In addition, the electrolyte may be injected from one direction of the secondary battery 100, for example, from the left side in FIG. 7A, and the injected electrolyte may diffuse in the opposite direction by injection pressure and/or gravity. In addition, the injected electrolyte may also diffuse in a direction crossing the injection direction (up-down direction in FIG. 7A) due to capillary action, etc. However, in the example shown in FIG. 7A, the electrolyte does not diffuse uniformly, so that there is a difference in the distribution (degree of impregnation) of the electrolyte depending on the position.

FIG. 7B is a graph showing the intensity of the emitted electromagnetic waves E measured by the sensor 230 when a high frequency R of a predetermined frequency is applied to the secondary battery 100 of FIG. 7A, according to an example. In FIG. 7B, an X-axis represents the position (P) based on the left end (position (P) is 0) of the secondary battery 100, and a Y-axis represents the relative intensity (I) of the electromagnetic wave E. The frequency of the applied high frequency R may be a frequency corresponding to a natural frequency of a specific material included in the electrolyte, such as Li, P, F, EC, DME, or the like.

Referring to FIG. 7B, the intensity (I) of the emitted electromagnetic waves E detected by the sensor 230 differs depending on the position (P) of the secondary battery 100. More specifically, as the position (P) moves further away from the left end, the intensity of the emitted electromagnetic waves E gradually decreases, and shows a value close to 0 at the end. According to this, it can be seen that in the secondary battery 100, there is a relatively large amount of electrolyte on the left portion, but less electrolyte toward the right. That is, it can be seen that the impregnation of the electrolyte was not uniform throughout the secondary battery 100.

As another example, the intensity of the emitted electromagnetic waves E detected by the sensor 230 may be used to identify the shape and/or thickness of the SEI film formed in the activation process.

More specifically, as the activation process progresses, not only is an SEI film formed due to a chemical reaction between lithium ions and additives in the electrolyte, but the chemical composition of the electrolyte between the positive electrode 10 and the negative electrode 20, more specifically, between the positive electrode active material layer and the negative electrode active material layer, changes. In this case, when a high frequency R corresponding to the natural frequency of a material that is included in the product of the activation process and increases in amount and/or a material that is included in the reactant of the activation process and decreases in amount is applied to the secondary battery 100, the intensity of the emitted electromagnetic waves E detected by the sensor 230 may also increase or decrease.

By using this technique, it is possible to detect changes in components inside the secondary battery 100, and based on this, it is also possible to diagnose the shape of the SEI film or estimate its thickness. In addition, by detecting the emitted electromagnetic waves E through an area scan of the high frequency generator 220 and/or the sensor 230, the changes in components may be identified by position. In addition, by simultaneously applying the high frequencies R of multiple frequencies using the high frequency generator 220, it is possible to simultaneously identify changes in components of a plurality of materials.

As another example, the intensity of the emitted electromagnetic waves E detected by the sensor 230 may be used to identify the presence or position of a foreign substance included in the secondary battery 100.

More specifically, the secondary battery 100 may include unnecessary foreign substances during the manufacturing process. In particular, when metal foreign substances such as iron (Fe), chromium (Cr), zinc (Zn), or the like other than the electrode active material or electrolyte are included in the secondary battery 100, this may cause a short circuit or the like, thereby causing defects in the secondary battery 100. In this case, when a high frequency R corresponding to the natural frequency of the foreign substance is applied to the secondary battery 100, the sensor 230 may detect emitted electromagnetic waves E of considerable intensity. By using this, it is possible to identify whether there are foreign substances inside the secondary battery 100.

At this time, by detecting the emitted electromagnetic waves E through an area scan of the high frequency generator 220 and/or the sensor 230, the position where the foreign substance is present may also be identified. In addition, by simultaneously applying the high frequencies R of multiple frequencies using the high frequency generator 220, the presence or position of a plurality of foreign substances can be identified simultaneously.

The processor 240 may determine the internal state of the secondary battery 100 based on an electrical signal output from the sensor 230. More specifically, the processor 240 may process the electrical signal output from the sensor 230 to calculate the intensity of the emitted electromagnetic waves E. In addition, the processor 240 may identify the presence and/or amount of a specific material based on the calculated intensity of the emitted electromagnetic waves E. In some embodiments, the electrical signal may include information about the position where the electromagnetic wave E is emitted from the secondary battery 100, and the processor 240 may identify where the specific material is located in the secondary battery 100 based on the information about the position.

The processor 240 may also use high frequency related information input from the high frequency generator 220 to identify the type or position of a specific material present inside the secondary battery 100. For example, when the high frequency related information is information indicating the frequency of the applied high frequency R, the processor 240 may identify that a material having a frequency corresponding to the high frequency R of the corresponding frequency is a specific material present inside the secondary battery 100. In addition, when the high frequency related information is information indicating a position where the high frequency R is applied in the secondary battery 100, the processor 240 may identify where the specific material is located in the secondary battery 100 based on the position.

Next, a secondary battery inspection method according to one embodiment of the present disclosure will be described.

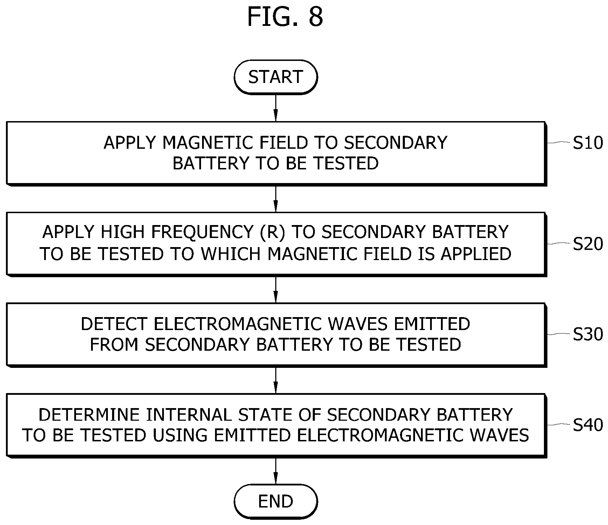

FIG. 8 is a flowchart showing an example of a secondary battery inspection method according to some embodiments of the present disclosure. Hereinafter, a description will be given of performing the secondary battery inspection method of FIG. 8 using the secondary battery inspection apparatus 200 illustrated in FIG. 5. Accordingly, matters not specifically described herein with respect to the secondary battery inspection method may be equally applied to matters described herein with reference to FIG. 5. However, the description herein is not limited to performing the secondary battery inspection method according to the present embodiment using the secondary battery inspection apparatus 200 illustrated in FIG. 5.

According to one aspect of the present embodiment, there is no special limitation on the timing of performing the secondary battery inspection method illustrated in FIG. 8. For example, the secondary battery inspection method may be performed during the process of manufacturing a secondary battery, during a quality inspection process performed after manufacturing a secondary battery, or during actual use of a secondary battery after manufacturing the secondary battery. **In** particular, the secondary battery inspection method illustrated in FIG. 8 may be performed after performing an impregnation process on a manufactured secondary battery, or while performing an activation process or after completing the activation process, but is not limited thereto.

Referring to FIG. 8, a magnetic field is applied to a secondary battery to be tested S10. The strength of the applied magnetic field may be, for example, 0.01 to 4 Tesla (T). To this end, a magnetic field generator may be disposed near the secondary battery to be tested, and the magnetic field to be applied may be generated using the magnetic field generator. When the magnetic field is applied to the secondary battery to be tested, the rotation axes of protons of the material present inside the secondary battery to be tested may all be arranged parallel to each other in a direction that conforms to the magnetic flux direction of the magnetic field. As a result, the material present inside the secondary battery to be tested may be arranged to have relatively low energy.

Then, a high frequency of a predetermined frequency is applied to the secondary battery to which the magnetic field is applied (S20). For this purpose, a high frequency generator may be disposed near the secondary battery to be tested, and the high frequency to be applied may be generated using this high frequency generator. Here, high frequency R may refer to a radio frequency having a frequency in the range of, for example, 10³ to 10²⁰ hertz (Hz).

According to one aspect of the present embodiment, the frequency of the high frequency applied in S20 may be a resonance frequency of a material to be applied, which is one of the materials inside the secondary battery to be tested. As a result, electromagnetic waves (emitted electromagnetic waves) due to the resonance phenomenon of the material may be emitted from the secondary battery to be tested.

According to another aspect of the present embodiment, in S20, the frequency of the high frequency applied to the secondary battery to be tested may be changed. Alternatively, in S20, the position of the secondary battery to which the high frequency is applied may be moved (e.g. moved relative to the magnetic field generator 210). Alternatively, in S20, high frequencies of multiple frequencies may be applied simultaneously to the secondary battery to be tested.

Next, the emitted electromagnetic waves emitted from the secondary battery to which the high frequency has been applied are detected (S30). For this purpose, a sensor may be installed around the secondary battery to be tested to detect emitted electromagnetic waves. There are no special restrictions on the installation position, size, shape, and the like of the sensor.

According to one aspect of the present embodiment, the intensity of the emitted electromagnetic waves detected in S30 may vary depending on the internal structure or condition of the secondary battery to be tested, the presence or absence of a specific material, and the like.

For example, the secondary battery to be tested may be in a state before the activation process is initiated, after the injection of the electrolyte is completed after completion of manufacturing. In addition, the high frequency applied in S20 may be a high frequency of a resonance frequency corresponding to the natural frequency of a material included in the electrolyte.

In the secondary battery to be tested after the injection of the electrolyte is completed, the injected electrolyte diffuses uniformly throughout the entire battery, or does not diffuse uniformly, so that the distribution (degree of impregnation) of the electrolyte differs depending on the position. In the former case, since the distribution of the electrolyte inside the secondary battery to be tested is the same regardless of the position, the intensity of the emitted electromagnetic wave detected in S30 may also be the same regardless of the position in the secondary battery to be tested. On the other hand, in the latter case, since the distribution of the electrolyte inside the secondary battery to be tested differs depending on the position, the intensity of the emitted electromagnetic wave detected in S30 may also differ depending on the position in the secondary battery to be tested.

As another example, the secondary battery to be tested may be a secondary battery that is undergoing or has completed the activation process. **In** addition, the high frequency applied in S20 may be a high frequency of a frequency corresponding to the natural frequency of a material that is included in the product of the activation process and increases in amount and/or a material that is included in the reactant of the activation process and decreases in amount.

During or after the activation process, the chemical composition of the electrolyte between the positive electrode active material layer and the negative electrode active material layer changes as the activation process progresses. As a result, the intensity of the emitted electromagnetic waves detected in S30 may also change in response to changes in the chemical composition.

As another example, the secondary battery to be tested may be a secondary battery including one or more metal foreign substances therein. In addition, the high frequency applied in S20 may be a high frequency of a frequency corresponding to the natural frequency of the foreign substance. In such cases, due to the presence of metal foreign substance, a considerable amount of emitted electromagnetic waves may be detected in S30.

Next, the internal state of the secondary battery to be tested is determined using the emitted electromagnetic waves detected in S30 (S40). More specifically, in S40, the intensity of the detected emitted electromagnetic waves is calculated, and based on the calculated intensity, the presence and/or amount of a specific material may be identified. In addition, in S40, it is also possible to identify the type or position of specific materials present inside the secondary battery to be tested.

According to an embodiment of the present disclosure, it is possible to identify an internal state of a secondary battery, such as the degree of electrolyte impregnation or the presence of foreign substances, without destroying the secondary battery in which an activation process is in progress or completed.

According to an embodiment of the present disclosure, the quality or shape of an SEI film can also be identified in real time even during the progress of the activation process.

However, the effects obtainable through the present disclosure are not limited to the effects described herein, and other technical effects not mentioned will be clearly understood by those skilled in the art from the description of the technology described herein.

Although the present disclosure has been described with reference to the embodiments shown in the drawings, these are merely examples, and those skilled in the art will understand that various modifications and equivalent other embodiments are possible therefrom.

Therefore, the technical protection scope of the present disclosure should be defined by the claims herein.

Examples are set out in the following clauses:
1. A secondary battery inspection apparatus comprising:
   a magnetic field generator configured to apply a magnetic field to a secondary battery to be tested;
   a high frequency generator configured to generate a high frequency of a predetermined frequency and apply the high frequency to the secondary battery to be tested;
   a sensor configured to detect electromagnetic waves emitted from the secondary battery to be tested to which the high frequency is applied while the magnetic field is applied; and
   a processor configured to determine an internal state of the secondary battery to be tested using the emitted electromagnetic waves detected by the sensor.
2. The secondary battery inspection apparatus of clause 1, wherein the high frequency generator generates the high frequency of a resonance frequency corresponding to a natural frequency of a material inside the secondary battery to be tested and applies the high frequency to the secondary battery to be tested.
3. The secondary battery inspection apparatus of clause 2, wherein the high frequency generator simultaneously generates high frequencies of multiple frequencies and applies the high frequencies to the secondary battery to be tested.
4. The secondary battery inspection apparatus of clause 2 or clause 3, wherein the high frequency generator applies the high frequency of the resonance frequency while scanning the secondary battery to be tested, or the sensor detects the emitted electromagnetic waves while scanning the secondary battery to be tested.
5. The secondary battery inspection apparatus of any of clauses 2 to 4, wherein the processor determines the internal state of the secondary battery to be tested based on at least one of an intensity of the emitted electromagnetic wave or a position from which the emitted electromagnetic wave is emitted from the secondary battery.
6. The secondary battery inspection apparatus of any of clauses 2 to 5, wherein the secondary battery to be tested is a secondary battery in a state before starting an activation process after completion of manufacturing; and
   the processor determines an impregnation state of an electrolyte in the secondary battery to be tested.
7. The secondary battery inspection apparatus of clause 6, wherein the resonance frequency is a frequency corresponding to a natural frequency of a material included in the electrolyte of the secondary battery to be tested.
8. The secondary battery inspection apparatus of any of clauses 2 to 7, wherein the secondary battery to be tested is a secondary battery in a state after starting an activation process after completion of manufacturing; and
   the processor determines a shape of a solid electrolyte interface (SEI) film of the secondary battery to be tested.
9. The secondary battery inspection apparatus of clause 8, wherein the resonance frequency is a frequency corresponding to a natural frequency of at least one of a material included in an electrode active material of the secondary battery to be tested and a material included in the solid electrolyte interface film.
10. The secondary battery inspection apparatus of clause 8 or clause 9, wherein the processor determines a thickness of the solid electrolyte interface film of the secondary battery to be tested.
11. The secondary battery inspection apparatus of any of clauses 2 to 10, wherein the processor determines presence or absence of a foreign substance included in the secondary battery to be tested.
12. The secondary battery inspection apparatus of clause 11, wherein the foreign substance is a metal foreign substance and the resonance frequency is a frequency corresponding to a natural frequency of the metal foreign substance.
13. The secondary battery inspection apparatus of clause 12, wherein:
   the high frequency generator applies the high frequency of the resonance frequency while scanning the secondary battery to be tested or the sensor detects the emitted electromagnetic waves while scanning the secondary battery to be tested; and
   the processor determines a position of a foreign substance included in the the secondary battery to be tested.
14. A secondary battery inspection method comprising:
   applying a magnetic field to a secondary battery to be tested;
   applying a high frequency of a predetermined frequency to the secondary battery to be tested to which the magnetic field is applied;
   detecting electromagnetic waves emitted from the secondary battery to be tested to which the high frequency is applied; and
   determining an internal state of the secondary battery to be tested using the emitted electromagnetic waves detected in the detecting of the electromagnetic waves.
15. The method of clause 14, wherein in the applying of the high frequency, the high frequency of a resonance frequency corresponding to a natural frequency of a material inside the secondary battery to be tested is applied to the secondary battery to be tested.
16. The method of clause 15, wherein in the applying of the high frequency, high frequencies of multiple frequencies are simultaneously applied to the secondary battery to be tested.
17. The method of clause 15 or clause 16, wherein the secondary battery to be tested is a secondary battery in a state before starting an activation process after completion of manufacturing; and
   the method further comprises determining an impregnation state of an electrolyte in the secondary battery.
18. The method of any of clauses 15 to 17, wherein the secondary battery to be tested is a secondary battery in a state after starting an activation process after completion of manufacturing; and
   the method further comprises determining a shape of a solid electrolyte interface (SEI) film of the secondary battery to be tested.
19. The method of clause 18, further comprising determining presence or absence of a foreign substance included in the secondary battery to be tested.
20. A method of manufacturing a secondary battery, comprising:
   an inspection process of inspecting an internal state of the secondary battery using a high frequency of a resonance frequency corresponding to a natural frequency of a material inside the secondary battery, wherein the inspection process includes:
   applying a magnetic field to the secondary battery;
   applying the high frequency of a predetermined frequency to the secondary battery to which the magnetic field is applied;
   detecting electromagnetic waves emitted from the secondary battery to be tested to which the high frequency is applied; and
   determining an internal state of the secondary battery to be tested using the emitted electromagnetic waves detected in the detecting of the electromagnetic waves.

## Claims

1. A secondary battery inspection apparatus comprising:
a magnetic field generator configured to apply a magnetic field to a secondary battery to be tested;
a high frequency generator configured to generate a high frequency of a predetermined frequency and apply the high frequency to the secondary battery to be tested;
a sensor configured to detect electromagnetic waves emitted from the secondary battery to be tested to which the high frequency is applied while the magnetic field is applied; and
a processor configured to determine an internal state of the secondary battery to be tested using the emitted electromagnetic waves detected by the sensor.

2. The secondary battery inspection apparatus of claim **1,** wherein the high frequency generator is configured to generate the high frequency of a resonance frequency corresponding to a natural frequency of a material inside the secondary battery to be tested and applies the high frequency to the secondary battery to be tested.

3. The secondary battery inspection apparatus of claim 2, wherein the high frequency generator is configured to simultaneously generate high frequencies of multiple frequencies and to apply the high frequencies to the secondary battery to be tested.

4. The secondary battery inspection apparatus of claim 2 or claim 3, wherein the high frequency generator is configured to apply the high frequency of the resonance frequency while scanning the secondary battery to be tested, and/or the sensor is configured to detect the emitted electromagnetic waves while scanning the secondary battery to be tested.

5. The secondary battery inspection apparatus of any of claims 2 to 4, wherein the processor is configured to determine the internal state of the secondary battery to be tested based on at least one of an intensity of the emitted electromagnetic wave and a position from which the emitted electromagnetic wave is emitted from the secondary battery.

6. The secondary battery inspection apparatus of any of claims 2 to 5, wherein the secondary battery to be tested is a secondary battery in a state before starting an activation process after completion of manufacturing; and
the processor is configured to determine an impregnation state of an electrolyte in the secondary battery to be tested.

7. The secondary battery inspection apparatus of claim 6, wherein the resonance frequency is a frequency corresponding to a natural frequency of a material included in the electrolyte of the secondary battery to be tested.

8. The secondary battery inspection apparatus of any of claims 2 to 7, wherein the secondary battery to be tested is a secondary battery in a state after starting an activation process after completion of manufacturing; and
the processor is configured to determine a shape of a solid electrolyte interface (SEI) film of the secondary battery to be tested.

9. The secondary battery inspection apparatus of claim 8, wherein the resonance frequency is a frequency corresponding to a natural frequency of at least one of a material included in an electrode active material of the secondary battery to be tested and a material included in the solid electrolyte interface film.

10. The secondary battery inspection apparatus of claim 8 or claim 9, wherein the processor is configured to determine a thickness of the solid electrolyte interface film of the secondary battery to be tested.

11. The secondary battery inspection apparatus of any of claims 2 to 10, wherein the processor is configured to determine presence or absence of a foreign substance included in the secondary battery to be tested.

12. The secondary battery inspection apparatus of claim 11, wherein the foreign substance is a metal foreign substance and the resonance frequency is a frequency corresponding to a natural frequency of the metal foreign substance.

13. The secondary battery inspection apparatus of claim 12, wherein:
the high frequency generator is configured to apply the high frequency of the resonance frequency while scanning the secondary battery to be tested and/or the sensor is configured to detect the emitted electromagnetic waves while scanning the secondary battery to be tested; and
the processor is configured to determine a position of a foreign substance included in the the secondary battery to be tested.

14. A secondary battery inspection method comprising:
applying a magnetic field to a secondary battery to be tested;
applying a high frequency of a predetermined frequency to the secondary battery to be tested to which the magnetic field is applied;
detecting electromagnetic waves emitted from the secondary battery to be tested to which the high frequency is applied; and
determining an internal state of the secondary battery to be tested using the emitted electromagnetic waves detected in the detecting of the electromagnetic waves.

15. A method of manufacturing a secondary battery, comprising:
an inspection process of inspecting an internal state of the secondary battery using a high frequency of a resonance frequency corresponding to a natural frequency of a material inside the secondary battery, wherein the inspection process includes a method according to claim 14.
